# EUROPÄISCHE PATENTSCHRIFT

(11) **EP 3 915 336 B1**
(45) Veröffentlichungstag und Bekanntmachung des Hinweises auf die Patenterteilung: **08.11.2023**
(21) Anmeldenummer: 20701605.6
(22) Anmeldetag: 22.01.2020
(51) Int. Cl.: H05B 45/10, H01S 5/042, H01S 5/068, H01S 5/0683

(54) **TREIBERSCHALTUNG, VERFAHREN ZUR LASERANSTEUERUNG, SOWIE OPHTHALMOLOGISCHE LASERBEHANDLUNGSVORRICHTUNG**
DRIVER CIRCUIT, METHOD FOR LASER ACTUATION, AND OPHTHALMOLOGICAL LASER TREATMENT DEVICE
CIRCUIT DE COMMANDE, PROCÉDÉ DE PILOTAGE DE LASER, ET DISPOSITIF OPHTALMOLOGIQUE DE TRAITEMENT AU LASER

(30) Priorität: 22.01.2019 CH 702019
(43) Veröffentlichungstag der Anmeldung: 01.12.2021
(73) Patentinhaber: Meridian AG, 3608 Thun (CH)
(72) Erfinder: STETTER, Michael, 4574 Lüsslingen (CH)
(74) Vertreter: Braun, André jr.
(86) Internationale Anmeldenummer: PCT/EP2020/051509
(87) Internationale Veröffentlichungsnummer: WO 2020/152217

(56) Entgegenhaltungen:
- EP-A1- 1 648 204
- EP-A1- 2 385 749
- EP-B1- 1 648 204
- EP-B1- 2 385 749
- WO-A1-2005/007002
- JP-A- 2012 059 920
- JP-A- 2012 138 421
- US-A1- 2010 072 898
- US-A1- 2017 311 403

## Beschreibung

### TECHNISCHES GEBIET

Die Erfindung bezieht sich auf ein Verfahren zum Betreiben einer Treiberschaltung zur Erzeugung eines Stromflusses durch eine Lichtquelle einer ophthalmologischen Laserbehandlungsvorrichtung und auf eine ophthalmologische Laserbehandlungsvorrichtung.

### STAND DER TECHNIK

Bei der Erfindung wird von der WO 2013/046285 A1 ausgegangen. Dort wird eine Treiberschaltung für eine Lichtquelle (z.B. lichtemittierende Diode LED) offenbart, welche eine Kompensation eines umgebungsbedingt veränderlichen Spannungsabfalls über der LED ermöglicht. Hierfür ist parallel zum ersten Stromtreiberpfad ein zweiter geregelter Shunt-Stromtreiberpfad vorhanden, dessen elektrischer Widerstand so geregelt wird, dass die Wärmedissipation im Shunt-Widerstand dem veränderlichen Strom durch die LED entgegenwirkt und dadurch die Lichtleistung der LED stabilisiert wird.

DE 10 2016 212 928 A1 offenbart ein Verfahren zur Erzeugung eines Laserpulses eines Anregungslasers in Reaktion auf einen Auslösezeitpunkt eines Auslösesignals. Dabei wird das Treiberansteuersignal unter Berücksichtigung des zeitlichen Abstands des aktuellen zum vorhergehenden Auslösezeitpunkt erzeugt.

DE 103 93 192 T5 offenbart eine Schaltung zur gemeinsamen Stromversorgung mehrerer lichtemittierende Dioden (LEDs), wobei die LEDS in parallelen Strompfaden angeordnet sind und jeder LED ein eigener Stromregler zur Regelung ihrer Lichtleistung zugeordnet ist.

DE 20 2010 017 580 U1 offenbart eine Schaltungsanordnung zur Reduzierung der Verlustleistung linearer Stromtreiber für LEDs. Dabei wird eine Steuergrösse für die LED-Versorgungsspannung aus der Verlustleistung der Treiberstufe ermittelt und als Steuersignal auf ein Regelnetzwerk zur Einstellung der LED-Versorgungsspannung geleitet. Die Treiberschaltung ist unabhängig von der Art der LED und ist für eine statische oder dynamische Ansteuerung geeignet.

Aus JP 2012 138421 A und JP 2012 059920 A sind jeweils Treiberschaltungen zur Erzeugung eines Stromflusses durch eine Lichtquelle bekannt, in denen zur Erzeugung eines in diskreten Stufen steuerbaren oder regelbaren Vorwiderstands für die Lichtquelle der Stromkreis in mindestens zwei parallele Stromzweige verzweigt ist und in jedem Stromzweig jeweils mindestens ein zuschaltbarer Parallelwiderstand vorhanden ist.

WO 2005/007002 A1 beschreibt ein Verfahren zum Betreiben eines Laser zum Einsatz in der Augenmedizin, aber auch allgemein in der Therapie biologischen Gewebes.

### DARSTELLUNG DER ERFINDUNG

Aufgabe der vorliegenden Erfindung ist es, ein Verfahren zum Betreiben einer Treiberschaltung zur Erzeugung eines Stromflusses durch eine Lichtquelle einer ophthalmologischen Laserbehandlungsvorrichtung und eine ophthalmologische Laserbehandlungsvorrichtung anzugeben, welche eine vereinfachte Regelung der Lichtleistung ermöglichen. Eine weitere Aufgabe der vorliegenden Erfindung ist es, eine ophthalmologische Laserbehandlungsvorrichtung vorzuschlagen, die dank präzis geformten Laserpulsen verbesserte ophthalmologische Behandlungen ermöglicht. Diese Aufgaben werden erfindungsgemäss durch die Gegenstände der unabhängigen Ansprüche gelöst. Weitere Merkmale, insbesondere in Unteransprüchen oder Kombination von Unteransprüchen oder Kombinationen von Ausführungsbeispielen sind optional und daher als insbesondere, bevorzugt o.ä. bezeichnet, sind also nicht erfindungswesentlich und dienen vielmehr zur Erzielung weiterer Vorteile oder Effekte.

In vielen Anwendungen der Laserbearbeitung von Materialien und Gewebe, insbesondere in ophthalmologischen Laserbehandlungen, ist es notwendig, Laserstrahl-Pulse mit bestimmten zeitlichen Eigenschaften zu erzeugen, um die Effizienz der Bearbeitung bzw. Behandlung zu optimieren und Nebenwirkungen zu minimieren: das betrifft den Pulsanstieg, den Pulsverlauf und den Pulsabfall. Dies gilt insbesondere beim Einsatz von reproduzierbaren Pulsen (Einzelpulse oder Pulszüge) unterhalb von Millisekunden für ophthalmologische Laserbehandlungen. Z.B. sind für die Selektive Retina Lasertherapie (SRT) Pulslängen von wenigen Mikrosekunden erforderlich. Die Pulse müssen einen geregelten reproduzierbaren Anstieg und Verlauf für Behandlungen an der Prozessschwelle aufweisen. Die vorliegende Erfindung beschreibt ein dafür geeignetes Verfahren zum Betreiben einer Treiberschaltung zur Erzeugung eines Stromflusses durch eine Lichtquelle einer ophthalmologischen Laserbehandlungsvorrichtung nach Anspruch 1 und eine ophthalmologische Laserbehandlungsvorrichtung nach Anspruch 6. Erfindungsgemäß lassen sich ophthalmologische Laserbehandlungsvorrichtungen realisieren, bei denen die Regelung des Lasers oder die Laserdiode in diskreten Schritten durch Zu- oder Abschalten diskreter Parallel-Vorwiderstände und ohne analoge oder digitale Regler für den Vorwiderstand erfolgen kann. Darüber hinaus lassen sich dadurch ophthalmologische Laserbehandlungsvorrichtungen mit einer insgesamt einfachen, schnellen und grundsätzlich gegen äussere Einflüsse stabile Regelung des erzeugten Lichts realisieren. Solche ophthalmologische Laserbehandlungsvorrichtungen haben, gegenüber den aus dem Stand der Technik bekannten Vorrichtungen, den Vorteil, dass Laserpulse mit einer vorbestimmten Form präzis und einfach erzeugt werden können. Insbesondere die Fähigkeit, für alle Pulse von Pulszügen präzise geformte Pulse bilden zu können, ist im Bereich der ophthalmologischen Behandlungen sehr wichtig.

Diverse Ausführungsbeispiele der Erfindung betreffen u. a. : die Verwendung einer grösseren Anzahl N von Stromzweigen in der Treiberschaltung, z.B. N >= 2 oder N >= 5 oder N >=10; die Wahl von gleichen oder unterschiedlichen Parallelwiderständen; die Ansteuerung, d.h. Ein- oder Ausschaltung, jeweils eines Schalters pro Stromzweig durch einen Mikrocontroller oder programmierbare Logik oder eine Digital-Elektronik; und eine Spannungsquelle mit veränderbarer Ausgangsspannung.

Besonders wichtig in der Ophthalmologie ist die Verwendung von grünem oder gelbem Laserlicht. Zur Erzeugung von grünem bzw. gelbem Laserlicht werden üblicherweise frequenzverdoppelte, optisch gepumpte Lasersysteme (DPSSL, OPSL, etc.) verwendet. Gewisse Behandlungsmethoden, bspw. Selective Retina Therapy (SRT) oder Mikropuls/"Sub-Threshold"-Laserverfahren verlangen Pulse im Mikrosekundenbereich. Um derartige schnelle Pulse mit einer erfindungsgemässen ophthalmologischen Laserbehandlungsvorrichtung erzeugen zu können, ist es besonders vorteilhaft, wenn eine gewisse Zeit vor dem eigentlich gewünschten Laserpuls der Strom der Laserdiode oder des Lasers bereits auf einen gewissen Wert angehoben werden kann, so dass die Laserbehandlungsvorrichtung dann schnell den eigentlich gewünschten Puls abzugeben in der Lage ist.

Vorteilhaft ist es auch, wenn die Laserbehandlungsvorrichtung derart konfiguriert ist, dass sie gewisse zeitliche Abfolge der Schalterkombinationen zulässt, damit Lichtpulsen mit einer spezifischen Pulsform erzeugt werden können. Von Vorteil für die Ophthalmologie ist die Erzeugung von möglichst "rechteckförmigen" Pulsformen, also Pulsen mit einer sehr kurzen Einschaltzeit gefolgt von einer konstanten Leistung. Die erfindungsgemässe ophthalmologische Laserbehandlungsvorrichtung benötigt zur Erzeugung von sehr kurzen aber auch beliebig langen Laser-Pulsen, im Gegensatz zu den bekannten Vorrichtungen, eine einzige Treiberschaltung. Dies ermöglicht, dass mit einer einzigen Laserbehandlungsvorrichtung verschiedene in der Ophthalmologie bekannte Behandlungsmethoden, wie zum Beispiel die Selective Retina Therapy (SRT), Mikropuls/"Sub-Threshold"-Laserverfahren oder die traditionelle Laser-Photokoagulation, verwendet werden können. Bisher waren hierzu in der Ophthalmologie mehrere Vorrichtungen erforderlich, beispielsweise eine CW-Kavität mit Treiber und zusätzlich eine gütegeschaltete Kavität (Q-Switched) mit einem eigenen Treiber sowie ein optischer Umschalter oder gar zwei vollständig getrennte Vorrichtungen. Dadurch kann eine wesentlich einfachere Laserbehandlungsvorrichtung als bisher zur Verfügung gestellt werden.

Ausserdem kann durch die Möglichkeit, nahezu rechteckige Lichtpulse zu bilden, dieselbe Energie in derselben Zeit am Behandlungsort im Auge deponiert werden, jedoch bei geringerer absoluter Lichtleistung. Dies ist in der Ophthalmologie besonders vorteilhaft um eine möglichst effiziente Behandlung bei möglichst geringer Schädigung des Gewebes zu erzielen.

Dank einer erfindungsgemässen ophthalmologischen Laserbehandlungsvorrichtung kann ausserdem ein guter Wirkungsgrad bei der Erzeugung des Laserlichts (Umwandlung elektrische Energie in Laserlichtenergie) erzielt werden. Dies ist von Vorteil da hierdurch eine Laserbehandlungsvorrichtung ohne Lüfter gebaut werden kann, was die Verwendung dieser beispielsweise in Operationssälen wesentlich erleichtert.

Wichtig zu beachten ist, dass für die "Selective Retina Therapy" (SRT) Laserpulse von einigen Mikrosekunden und darunter benötigt werden. Bisher wurden dazu aufwändige, teure gütegeschaltete Lasersysteme verwendet. Mithilfe der beschriebenen ophthalmologischen Laserbehandlungsvorrichtung kann ein einfacheres CW-Lasersystem (bspw. DPSSL, OPSL, etc.) so angesteuert werden, dass Laserpulse mit der erforderlichen Pulsdauer und Laserleistung erzeugt werden können. Dies ermöglicht den Aufbau eines weitaus preiswerteren SRT-Behandlungsvorrichtung als bisher möglich, sogar noch mit der zusätzlichen Möglichkeit längere Laserpulse für andere ophthalmologischen Behandlungsmethoden zu erzeugen (bspw. Mikropuls/"Sub-Threshold"-Laserverfahren und/oder traditionelle Laser-Photokoagulation).

Besonders vorteilhaft ist es, wenn die erfindungsgemässe ophthalmologische Laserbehandlungsvorrichtung derart konfiguriert ist, dass Laserpulse mit einer Dauer im Bereich von 0.5 - 50 Mikrosekunden, bevorzugt 1 - 10 Mikrosekunden, erzeugt werden können; und/oder dass Laserpulse mit einem schnellen reproduzierbaren Anstieg im Bereich von 0.1 - 5 Mikrosekunden, bevorzugt 0.5 - 2 Mikro-sekunden, erzeugt werden können.

Weitere Ausführungsbeispiele, Vorteile und Anwendungen der Erfindung ergeben sich aus den abhängigen Ansprüchen, aus den Anspruchskombinationen und aus der nun folgenden Beschreibung und den Figuren.

### KURZE BESCHREIBUNG DER ZEICHNUNGEN

Es zeigen schematisch
- Fig. 1: eine einfache selbststabilisierende Treiberschaltung gemäss Stand der Technik;
- Fig. 2: ein erstes erfindungsgemässes Ausführungsbeispiel einer Treiberschaltung;
- Fig. 3: ein zweites erfindungsgemässes Ausführungsbeispiel einer Treiberschaltung mit Mikrocontroller;
- Fig. 4, 5: dritte erfindungsgemässe Ausführungsbeispiele einer Treiberschaltung mit Mikrocontroller und Rückkopplung;
- Fig. 6: eine Strom-Lichtleistungs-Kennlinie einer Leuchtdiode (LED) oder Laserdiode (LD);
- Fig. 7: ein weitgehend ideales zeitliches Verhalten von Strom und Lichtleistung einer LED oder LD; und
- Fig. 8: ein reales zeitliches Verhalten von Strom und Lichtleistung einer Laserdiode.

In den Figuren sind gleiche oder funktionsgleiche Teile mit gleichen Bezugszeichen versehen.

### WEGE ZUR AUSFÜHRUNG DER ERFINDUNG

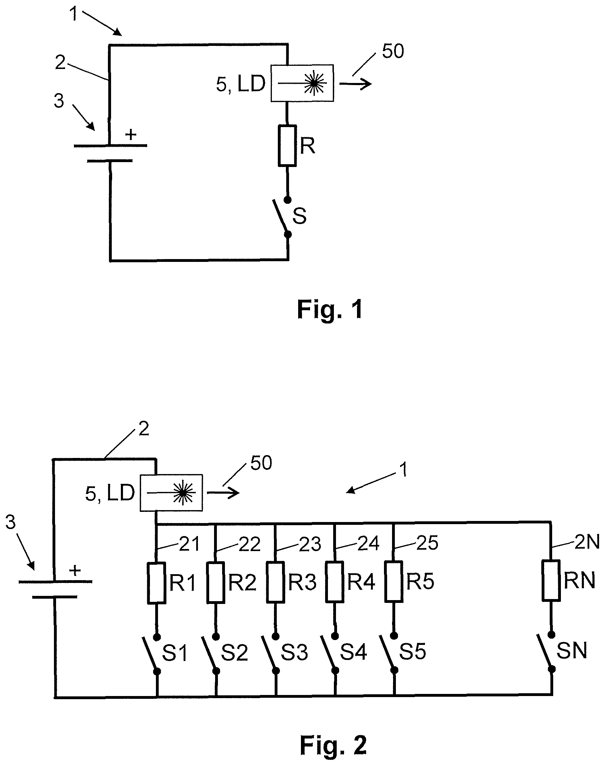

Fig. 1 zeigt das an sich bekannte Prinzip einer Treiberschaltung 1 zur Erzeugung von Lichtemission 50 mittels eines Stromkreises 2 mit einer Spannungsquelle 3, einer Lichtquelle 5, insbesondere Laserdiode LD, einem Vorwiderstand R und einem Schalter S. Die Schaltung ist selbststabilisierend und erfordert keine aktiven Bauteile oder Regler. Durch die Spannung der Spannungsquelle 3 und den Widerstandswert R kann die Stromstärke einfach festgelegt werden. Durch Öffnen und Schliessen des Stromkreises 2 mit dem Schalter S (z.B. MOSFET) kann der Strom und damit das Licht gepulst werden. Nachteilig hierbei ist, dass der Strom-Sollwert nur durch Ändern der Spannung der Spannungsquelle 3 oder durch Ändern des Widerstandswerts R variiert werden kann, was technisch nur mit nicht geringem Aufwand realisiert werden kann. Ausserdem kann durch eine hohe Spannung der Spannungsquelle 3 unter Umständen eine hohe Verlustleistung im Widerstand R entstehen.

Herkömmliche Treiberschaltungen beruhen z.B. auf Analogelektronik: Grundsätzlich kann der Strom beispielsweise mittels Operationsverstärker und entsprechenden Leistungshalbleitern geregelt werden. Nachteilig ist hierbei, dass Regler grundsätzlich instabil sein können und die Einstellung der Regler-Parameter und die Auswahl der Bauelemente nicht trivial ist, insbesondere im Fall von variablen Regel-Sollwerten. Verbreitet sind auch Digitalelektronik bzw. Digital-Schaltregler: Schaltregler-Stromkontroller bieten grundsätzlich die Möglichkeit einer guten Energieeffizienz. Nachteilig ist auch hier, dass komplexe Regler-Algorithmen erforderlich sind. Ausserdem sind sehr schnelle Mikrocontroller oder z.B. "field-programmable gate arrays" (FPGAs) erforderlich.

Gegenstand der Erfindung ist eine Treiberschaltung 1 und ein Verfahren zum Betreiben der Treiberschaltung 1 gemäss den unabhängigen Ansprüchen. Im folgenden werden hierzu Ausführungsbeispiele angegeben. Gegenstand der vorliegenden Erfindung ist darüber hinaus auch eine ophthalmologische Laserbehandlungsvorrichtung, die eine erfindungsgemässe Treiberschaltung umfasst.

Fig. 2 zeigt ein Ausführungsbeispiel einer Treiberschaltung 1 mit einem Stromkreis 2, der in N Parallelstromzweige 21, ..., 2N verzweigt ist, die jeweils einen Widerstand R1, ..., RN, auch Parallelwiderstand genannt, und einen Schalter S1,...,SN, insbesondere Ein-/Aus-Schalter S1,...,SN, in Serie aufweisen.

Das hier dargestellte Prinzip erlaubt die Entwicklung einer einfachen Elektronik-Hardware und Software zur Erzeugung von Lichtpulsen bei Laserdioden und Lasersystemen, insbesondere bei ophthalmologischen Laserbehandlungsvorrichtungen. Das Prinzip basiert auf dem in Fig. 1 beschriebenen Aufbau "Spannungsquelle mit Vorwiderstand". Der Vorwiderstand wird jedoch neu als Kombination von mehreren, einzeln schaltbaren Widerständen R1,...,RN realisiert.

Der Gesamt-Widerstand R kann, je nach Schalterstellungen, berechnet werden. Insbesondere gilt R⁻¹ = (R1ₐₙ⁻¹ + ... + Rnₐₙ⁻¹), wobei Index "an" jeweils den in einem angeschalteten Stromzweig angeordneten Widerstand P1ₐₙ, ..., Rnₐₙ bezeichnet und der Laufindex n <= N ist.

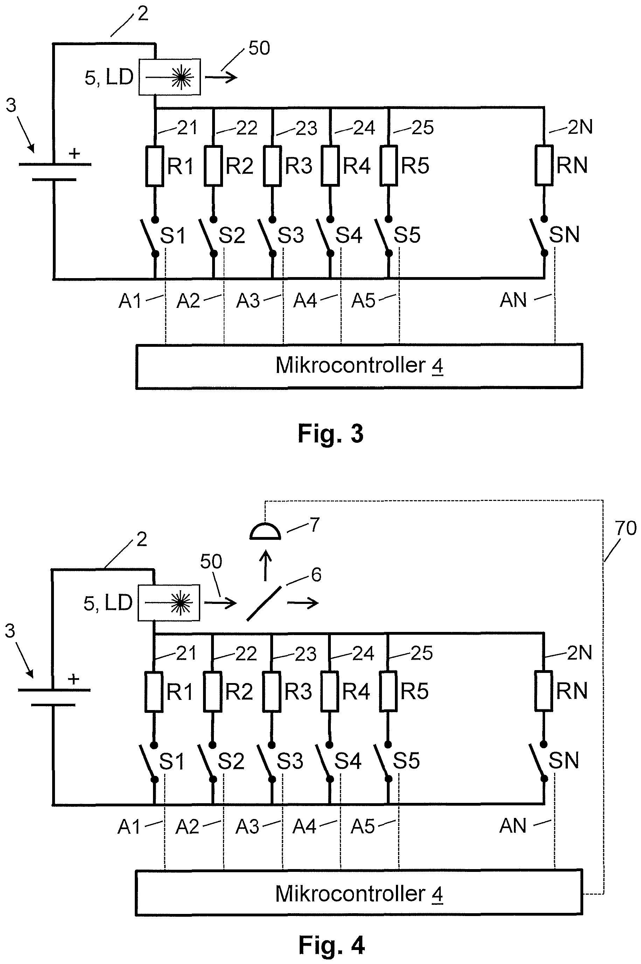

Fig. 3 - 5 zeigen, dass die Ansteuerung der Schalter S1 bis SN durch Digital-Elektronik oder einen Mikrocontroller 4 erfolgen kann. Die Zeitpunkte, zu denen die Schalter S1,...,SN ihren Zustand wechseln, also eine neue Schalterkombination eingestellt wird, ist variabel. Dies kann erfindungsgemäss sehr langsam aber auch sehr schnell erfolgen.

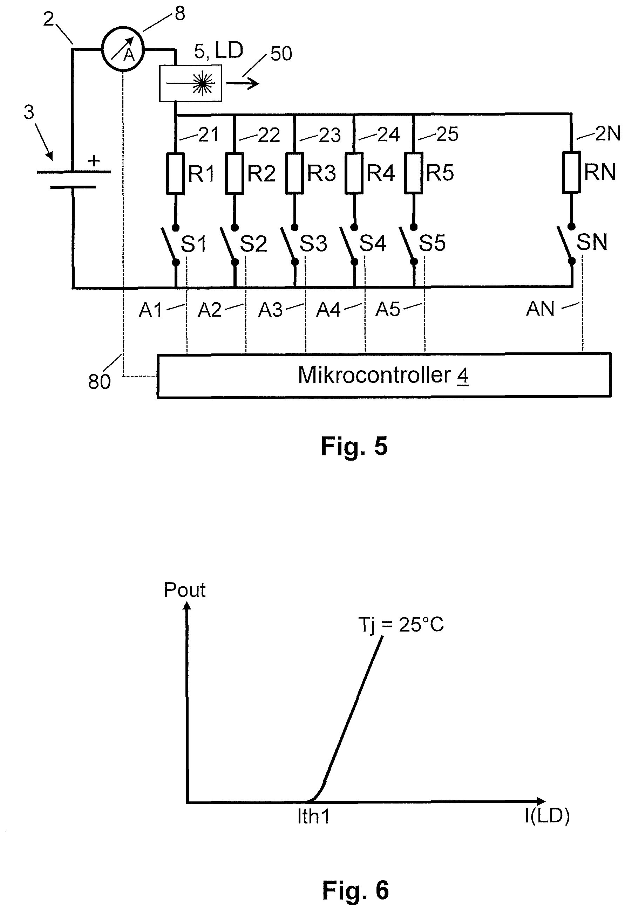

Gemäss Ausführungsbeispiel in Fig. 3 ist der Mikrocontroller 4, oder alternativ eine Digital-Elektronik, mit jedem Schalter S1,...,SN über jeweils einen Ansteuerpfad (A1,...,AN) verbunden. Gemäss Ausführungsbeispiel in Fig. 4 ist zusätzlich für die Lichtquelle 5 ein Lichtsensor 6, 7, insbesondere umfassend einen Strahlteiler 6 und Photodetektor 7, zur Messung der Lichtleistung der Lichtquelle 5 vorhanden, der über einen Rückkopplungspfad 70 zur Lichtleistungsregelung mit dem Mikrocontroller 4 oder alternativ mit der Digital-Elektronik verbunden ist. Gemäss Ausführungsbeispiel in Fig. 5 ist im Stromkreis 2 ein Stromsensor 8 zur Messung des Stroms durch die Lichtquelle 5 vorhanden und über einen Rückkopplungspfad 80 zur Stromstärkeregelung mit dem Mikrocontroller 4 oder alternativ der Digital-Elektronik verbunden. Die Ausführungsbeispiele von Fig. 4 und 5 können auch in Kombination miteinander realisiert sein, d.h. dass sowohl eine Rückkopplung für die Stromstärke als auch für die Lichtleistung verwendet wird.

Der Begriff Mikrocontroller 4 soll auch eine programmierbare Logik mitumfassen. Insbesondere umfasst der Mikrocontroller 4 Software, welche in der Treiberschaltung 1 implementiert und Bestandteil der Treiberschaltung ist bzw. die zur Ausführung des Verfahrens programmiert ist.

In weiteren Ausführungsbeispielen haben einige oder alle Parallelwiderstände R1, ..., RN denselben Widerstandswert; oder einige oder alle Parallelwiderstände R1,...,RN haben unterschiedliche Widerstandswerte, insbesondere jeweils verdoppelte Widerstandswerte gemäss der Formel RN=2^{(N-1)}R1, wobei N = Anzahl Stromzweige bzw. Anzahl Parallelwiderstände R1,...,RN.

In Ausführungsbeispielen können jeweils verdoppelte Widerstandswerte gegenüber dem nächstgelegenen Widerstand gewählt sein, also beispielsweise R1 = 1Ω, R2 = 2Ω, R3 = 4Ω, R4 = 8Ω, R5 = 16Ω, ... , RN = 2^{N} Ω, oder allgemeiner geschrieben: R2 = 2 * R1, R3 = 4 * R1, R4 = 8 * R1, R5 = 16 * R1, ..., RN = 2^{(N-1)} * R1.

In anderen, nicht dargestellten Ausführungsbeispielen kann die Spannungsquelle 3 Mittel zur Veränderung ihrer Ausgangsspannung umfassen; und/oder kann die Lichtquelle 5 eine Laserdiode LD oder ein Laserdioden-gepumptes oder Leuchtdioden(LED)-gepumptes Lasersystem, insbesondere ein diodengepumpter Festkörperlaser DPSSL oder ein kohärent optisch gepumpter Halbleiterlaser OPSL, sein.

Das Verfahren zum Betreiben der Treiberschaltung 1 besteht darin, dass in einem Stromkreis 2 eine Spannungsquelle 3, eine Lichtquelle 5, ein Vorwiderstand und ein Schalter angeordnet sind, wobei der Stromkreis 2 in mindestens zwei parallele Stromzweige 21, ..., 2N verzweigt ist, in jedem Stromzweig 21, ..., 2N ein Parallelwiderstand R1, ..., RN und ein Schalter S1,...,SN zum Zuschalten oder Abschalten des Parallelwiderstands R1, ..., RN vorhanden ist, wobei der Vorwiderstand dadurch in diskreten Stufen gesteuert oder geregelt wird, dass mindestens einer der Schalter S1,...,SN eingeschaltet oder ausgeschaltet wird.

Bevorzugt sind N Stromzweige 21, ..., 2N vorhanden, wobei N = natürliche Zahl grösser oder gleich 2. Desweiteren sollen 2^{N} Schalterkonfigurationen durch Ein- oder Aus-Stellung der N Schalter S₁,...,S_{N} vorhanden und insbesondere schaltbar sein, wobei der Vorwiderstand durch eine zeitliche Abfolge von Schalterkonfigurationen stufenweise gesteuert oder geregelt wird.

Fig. 6 zeigt eine typische Kennlinie einer Laserdiode (LD) oder Leuchtdiode (LED) für die emittierte Lichtleistung Pₒᵤₜ [in Watt] als Funktion der Stromstärke I [in Ampere], hier dargestellt für eine Sperrschicht-Temperatur Tⱼ von 25 °C. Eine Lichtemission findet erst statt, nachdem der Strom I einen gewissen Schwellwert Iₜₕ₁ überschritten hat.

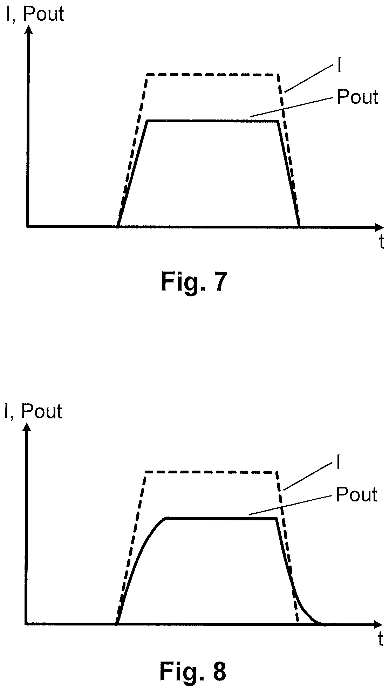

Fig. 7 zeigt ein weitgehend ideales Verhalten der zeitlichen Kennlinie von Strom und Lichtleistung einer Laserdiode (LD) oder Leuchtdiode (LED). Dabei ist häufig die abgegebene Lichtleistung von Laserdioden oder Leuchtdioden und Lasersystemen (DPSSL, OPSL, etc.) im hier betrachteten Zeitbereich so, dass die Ausgangs-Lichtintensität Pₒᵤₜ der elektrischen Stromstärke I durch die Laserdiode sehr schnell folgt.

Fig. 8 zeigt ein Beispiel, in dem die Laserdiode oder das Lasersystem im betrachteten Zeitbereich keinen direkt proportionalen Zusammenhang zwischen der Ausgangsleistung und dem Strom aufweist. Das Anschwingen und Ausschwingen tritt erst mit einer gewissen Verzögerung auf. Auch ein Überschwingen kann unter gewissen Umständen auftreten.

Reale Laserdioden und reale Spannungsquellen haben also nichtideale Eigenschaften. Hauptsächlich wirkt sich die parasitäre Serieninduktivität der Laserdiode und der Zuleitung aus. Ausserdem hat der ohmsche und induktive Innenwiderstand, eine begrenzte Kapazität und nichtideale Last-Regel-Eigenschaften der Spannungsquelle bei Einschalten der Schalter eine kurzzeitige Spannungsänderung zur Folge.

Derartige Nichtidealitäten von Laserdioden oder Lasersystemen können durch die erfindungsgemässe Treiberschaltung 1 und das erfindungsgemässe Verfahren und auch durch die offenbarten Ausführungsbeispiele verringert oder weitgehend kompensiert werden.

Erfindungsgemäß wird eine zeitliche Abfolge von Schalterkonfigurationen so ausgeführt, dass für die Lichtquelle 5 ein vorgegebener Strom-Zeit-Verlauf oder Lichtleistungs-Zeit-Verlauf Pₒᵤₜ(t) realisiert wird, insbesondere um ein nichtideales Verhalten der Lichtquelle 5 und/oder der Spannungsquelle 3 und/oder von Zuleitungen beim Einschalten der Lichtquelle 5 zumindest teilweise zu kompensieren. Hierdurch ist ausserdem die Möglichkeit der Laserpulsformung oder Laserpulsanpassung ("Pulse Design" oder "Shape Engineering") gegeben, also die Möglichkeit, die Laserpulsform (Pₒᵤₜ(t)) so zu gestalten, wie dies für die Anwendung, insbesondere die ophthalmologische Behandlung, optimal ist.

Erfindungsgemäß wird eine erste zeitliche Abfolge von Schalterkonfiguration so ausgeführt, dass zur Erzeugung kurzer Anstiegszeiten der Lichtleistung, z.B. im Bereich von 0.1 - 100 Mikrosekunden, zu Beginn eines Strompulses ein sehr kleiner Vorwiderstand eingestellt wird und dieser Vorwiderstand durch Ändern der Schalterkonfiguration schrittweise, insbesondere jeweils nach 1 Mikrosekunde, erhöht wird. Die erste zeitliche Abfolge wird also bevorzugt auf einer sehr kurzen Zeitskala, insbesondere Mikrosekunden oder Sub-Mikrosekunden wie z.B. 1 ns - 1000 ns oder bevorzugt 100 ns - 1000 ns, ausgeführt.

Ergänzend wird eine zweite zeitliche Abfolge von Schalterkonfiguration so ausgeführt, dass nach der ersten zeitlichen Abfolge mit fortschreitender Zeit die Lichtleistung der Lichtquelle 5 in Abhängigkeit einer Strommessung im Stromkreis 2 oder einer Lichtleistungsmessung der Stromquelle 5 durch stufenweises Verändern des Vorwiderstands geregelt wird. Die zweite zeitliche Abfolge wird bevorzugt auf einer gegenüber der ersten zeitlichen Abfolge langsameren Zeitskala, z.B. im Bereich von 1 - 1000 Mikrosekunden oder bevorzugt 5 - 500 Mikrosekunden oder besonders bevorzugt 10 - 200 Mikrosekunden, ausgeführt.

Ergänzend wird eine dritte zeitliche Abfolge von Schalterkonfigurationen so ausgeführt, dass im Verlauf eines Strompulses Schwankungen der Lichtleistung der Lichtquelle 5 aufgrund thermischer Effekte, insbesondere in der Spannungsquelle 3 und/oder in den Parallelwiderständen R1,...,RN, durch diskretes oder stufenweise Verändern des Vorwiderstands kompensiert werden. Die dritte zeitliche Abfolge wird bevorzugt auf einer nochmals langsameren Zeitskala, z.B. im Bereich von Sekunden oder Minuten, ausgeführt.

In weiteren Ausführungsbeispielen wird die Spannungsquelle 3 so gesteuert oder geregelt, dass zu Beginn eines Strompulses die Spannung erhöht gewählt wird und danach schrittweise reduziert wird, insbesondere um eine näherungsweise rechteckige Kurvenform der Lichtleistung Pₒᵤₜ(t) der Lichtquelle 5 als Funktion der Zeit t zu realisieren und/oder um die Verlustleistung in den Widerständen klein zu halten.

In weiteren Ausführungsbeispielen der Treiberschaltung und des Verfahrens kann das Anschwingen der Lichtquelle, insbesondere eines Lasers oder Laserdioden-gepumpten Lasersystems, dadurch verbessert werden, dass kontinuierlich oder während einer Vorlaufzeit vor der gewünschten Laserlichtabgabe der Pumpstrom für den Laser 5, insbesondere für die Laserdiode 5 oder Pump-Laserdiode 5, durch Schalten der Schalter S1,...,SN auf einen Wert knapp unterhalb des Schwellstroms Iₜₕ₁ gebracht wird. Die Vorlaufzeit kann z.B. im Bereich von 1 Mikrosekunde - 100 Mikrosekunden gewählt sein.

### BEZUGSZEICHENLISTE

- 1: Treiberschaltung, Lasertreiberschaltung, LED-Treiberschaltung
- 2: Stromkreis
- 21,...2N: Parallelstrompfade, parallele Stromzweige
- 3: Spannungsquelle
- 4: Mikrocontroller, Digital-Elektronik
- 5: Lichtquelle, Laser, Lasersystem, Laserdiode, Laserdioden-gepumptes Lasersystem, diodengepumpter Festkörperlaser (DPSSL), kohärent optisch gepumpter Halbleiterlaser (OPSL)
- 50: emittiertes Licht
- 6, 7: Lichtsensor
- 6: Strahlteiler
- 7: Photodetektor, Lichtleistungsmessung
- 70: Rückkopplungspfad zur Lichtleistungsregelung
- 8: Stromsensor, Strommessung
- 80: Rückkopplungspfad zur Stromstärkeregelung
- 9: Stromstärke [Ampere] durch die Laserdiode
- 10: Lichtleistung [Watt] der Laserdiode
- LD: Laserdiode
- R: elektrischer Widerstand
- R1,...,RN: elektrische Widerstände 1, 2, ..., N in parallelen Strompfaden
- S: Schalter, MOSFET
- S1,...,SN: Schalter in parallelen Strompfaden, MOSFETS
- N: Anzahl der Parallelstrompfade
- A1,...,AN: Ansteuerpfade 1, 2, ..., N vom Mikrocontroller zum 1., 2., ..., N.ten Schalter
- I: Stromstärke [Ampere] durch die Lichtquelle
- I(LD): Stromfluss durch die Laserdiode
- Iₜₕ₁: Strom-Schwellwert der Laserdiode
- Pₒᵤₜ: Lichtleistung [Watt] der Lichtquelle
- Tⱼ: Temperatur der Laserdiode, Junction- oder Sperrschicht-Temperatur
- t: Zeit [Sekunden]

## Patentansprüche

1. Verfahren zum Betreiben einer Treiberschaltung (1) zur Erzeugung eines Stromflusses durch eine Lichtquelle (5)einer ophthalmologischen Laserbehandlungsvorrichtung,
**dadurch gekennzeichnet, dass**
in einem Stromkreis (2) eine Spannungsquelle (3), die Lichtquelle (5), ein Vorwiderstand und ein Schalter angeordnet sind, wobei der Stromkreis (2) in mindestens zwei parallele Stromzweige (21, ..., 2N) verzweigt ist, in jedem Stromzweig (21, ..., 2N) ein Parallelwiderstand (R1,...,RN) und ein Schalter(S1,...,SN) zum Zuschalten oder Abschalten des Parallelwiderstands (R1,...,RN) vorhanden ist, wobei der Vorwiderstand dadurch in diskreten Stufen gesteuert oder geregelt wird, dass mindestens einer der Schalter (S1,...,SN) eingeschaltet oder ausgeschaltet wird,
wobei N Stromzweige (21, ..., 2N) vorhanden sind, wobei N eine natürliche Zahl grösser oder gleich 2 ist, wobei 2^{N} Schalterkonfigurationen durch Ein- oder Aus-Stellung der N Schalter (S1,...,SN) vorhanden sind und insbesondere schaltbar sind, wobei der Vorwiderstand durch eine zeitliche Abfolge von Schalterkonfigurationen stufenweise gesteuert oder geregelt wird,
wobei die zeitliche Abfolge von Schalterkonfigurationen so ausgeführt wird, dass für die Lichtquelle (5) ein vorgegebener Strom-Zeit-Verlauf oder Lichtleistungs-Zeit-Verlauf (Pₒᵤₜ(t)) realisiert wird, und wobei:
a) eine erste zeitliche Abfolge von Schalterkonfiguration so ausgeführt wird, dass zu Beginn eines Strompulses ein erster Vorwiderstand eingestellt wird, bevorzugt zur Erzeugung von Anstiegszeiten der Lichtleistung im Bereich von 0.1 - 100 Mikrosekunden, und dieser Vorwiderstand durch Ändern der Schalterkonfiguration schrittweise, insbesondere jeweils nach einem Zeitintervall im Bereich von 1 Mikrosekunde oder im Bereich von 1 ns - 1000 ns, erhöht wird; und
b) eine zweite zeitliche Abfolge von Schalterkonfiguration, insbesondere auf einer Zeitskala im Bereich von 1 - 1000 Mikrosekunden, so ausgeführt wird, dass mit fortschreitender Zeit, insbesondere nach der ersten zeitlichen Abfolge, die Lichtleistung (Pₒᵤₜ) der Lichtquelle (5) in Abhängigkeit einer Strommessung im Stromkreis (2) oder einer Lichtleistungsmessung der Stromquelle (5) durch stufenweises Verändern des Vorwiderstands geregelt wird; und
c) eine dritte zeitliche Abfolge von Schalterkonfigurationen, insbesondere auf einer Zeitskala im Bereich von Sekunden oder Minuten, so ausgeführt wird, dass im Verlauf eines Strompulses Schwankungen der Lichtleistung (Pₒᵤₜ) der Lichtquelle (5) aufgrund thermischer Effekte, insbesondere in der Spannungsquelle (3) und/oder in den Parallelwiderständen (R1,...,RN), durch stufenweises Verändern des Vorwiderstands kompensiert werden.

2. Verfahren nach Anspruch 1, **dadurch gekennzeichnet, dass** die Spannungsquelle (3) so gesteuert oder geregelt wird, dass zu Beginn eines Strompulses die Spannung erhöht gewählt wird und danach schrittweise reduziert wird, um eine näherungsweise rechteckige Kurvenform der Lichtleistung (Pₒᵤₜ(t)) der Lichtquelle (5) als Funktion der Zeit (t) zu realisieren und/oder um die Verlustleistung in den Widerständen zu verkleinern.

3. Verfahren nach einem der Ansprüche 1 oder 2, **dadurch gekennzeichnet, dass** die Lichtquelle ein Lasersystem (5), z.B. eine Laserdiode (5) oder ein diodengepumpter Laser (5), ist und die zeitliche Abfolge von Schalterkonfigurationen so ausgeführt wird, dass die Laserpulsform und Laserpulsfrequenz für ophthalmologische Anwendungen, insbesondere für die Selektive Retina Lasertherapie, angepasst oder optimiert wird.

4. Verfahren nach Anspruch 3, **dadurch gekennzeichnet, dass** die Laserpulse mit einer Dauer im Bereich von 0.5
- 50 Mikrosekunden, bevorzugt 1 - 10 Mikrosekunden, erzeugt werden; und/oder die Laserpulse mit einem schnellen reproduzierbaren Anstieg im Bereich von 0.1
- 5 Mikrosekunden, bevorzugt 0.5 - 2 Mikrosekunden, erzeugt werden.

5. Verfahren nach einem der Ansprüche 1 bis 4, wobei das Verfahren in einer ophthalmologischen Laserbehandlung, in einer Selective Retina Therapy (SRT) oder in einem Mikropuls/"Sub-Threshold"-Laserverfahren, angewendet wird.

6. Ophthalmologische Laserbehandlungsvorrichtung, insbesondere zur Selective Retina Therapy (SRT) oder zum Mikropuls/"Sub-Threshold"-Laserverfahren, umfassend eine Treiberschaltung (1) zur Erzeugung eines Stromflusses durch einen Laser oder eine Laserdiode (LD),
**dadurch gekennzeichnet, dass** 1
in einem Stromkreis (2) der Treiberschaltung eine Spannungsquelle (3), der Laser oder die Laserdiode (LD), ein Vorwiderstand und ein Schalter angeordnet sind, wobei zur Erzeugung eines in diskreten Stufen steuerbaren oder regelbaren Vorwiderstands für den Laser oder die Laserdiode (LD) der Stromkreis (2) in mindestens zwei parallele Stromzweige (21, ..., 2N) verzweigt ist und in jedem Stromzweig (21, ..., 2N) jeweils mindestens ein zuschaltbarer Parallelwiderstand (R1,...,RN) vorhanden ist,
wobei in jedem Stromzweig (21, ..., 2N) der Treiberschaltung (1) jeweils mindestens ein Schalter (S1,...,SN) zum Zuschalten oder Abschalten des Parallelwiderstands (R1,...,RN) vorhanden ist, und
wobei die Treiberschaltung (1) Mittel zur Ausführung des Verfahrens nach einem der Ansprüche 1 bis 5 umfasst.

7. Ophthalmologische Laserbehandlungsvorrichtung nach Anspruch 6, **dadurch gekennzeichnet, dass** die Treiberschaltung (1),
a) Parallelwiderstände (R1,...,RN) mit demselben Widerstandswert umfassen; und/oder
b) Parallelwiderstände (R1,...,RN) mit unterschiedlichen Widerstandswerten, insbesondere in einer Serie mit jeweils verdoppelten Widerstandswerten (RN=2^{(N-1)}R1), umfassen.

8. Ophthalmologische Laserbehandlungsvorrichtung nach einem der Ansprüche 6 oder 7, 17, **dadurch gekennzeichnet, dass**
a) in jedem Stromzweig (21, ..., 2N) der Treiberschaltung (1) der Schalter (S1,...,SN) in Serie zum Parallelwiderstand (R1,...,RN) angeordnet ist; und/oder
b) die Schalter (S1,...,SN) der Treiberschaltung (1) MOSFET-Schalter sind.

9. Ophthalmologische Laserbehandlungsvorrichtung nach einem der Ansprüche 6 bis 8, **dadurch gekennzeichnet, dass** die Treiberschaltung (1) eine Digital-Elektronik oder ein Mikrocontroller (4) zur Ansteuerung der Schalter (S1,...,SN) umfasst, insbesondere dass die Digital-Elektronik oder der Mikrocontroller (4) mit jedem Schalter (S1,...,SN) über jeweils einen Ansteuerpfad (A1,...,AN) verbunden ist.

10. Ophthalmologische Laserbehandlungsvorrichtung nach Anspruch 9, **dadurch gekennzeichnet, dass**
a) im Stromkreis (2) der Treiberschaltung (1) ein Stromsensor (8) zur Messung des Stroms durch den Laser oder die Laserdiode (LD) vorhanden ist und über einen Rückkopplungspfad (80) zur Stromstärkeregelung mit der Digital-Elektronik oder dem Mikrocontroller (4) verbunden ist; und/oder
b) für den Laser oder die Laserdiode (LD) ein Lichtsensor (6, 7) zur Messung der Lichtleistung (Pₒᵤₜ) des Lasers oder der Laserdiode (LD) vorhanden ist und über einen Rückkopplungspfad (70) zur Lichtleistungsregelung mit der Digital-Elektronik oder dem Mikrocontroller (4) verbunden ist.

11. Ophthalmologische Laserbehandlungsvorrichtung nach einem der Ansprüche 6 bis 10, **dadurch gekennzeichnet, dass**
a) die Spannungsquelle (3) der Treiberschaltung (1) Mittel zur Veränderung ihrer Ausgangsspannung umfasst; und/oder
b) der Laser oder eine Laserdiode (LD) ein Laserdioden-gepumptes oder LED-gepumptes Lasersystem, insbesondere ein diodengepumpter Festkörperlaser (DPSSL) oder ein kohärent optisch gepumpter Halbleiterlaser (OPSL), ist.

## Claims

1. A method for operating a driver circuit (1) for generating a current flow through a light source (5) of an ophthalmic laser treatment device,
**characterized in that**
a voltage source (3), the light source (5), a series resistor and a switch are arranged in a circuit (2), the circuit (2) being branched into at least two parallel current branches (21, ..., 2N), a parallel resistor (R1, ..., RN) and a switch (S1, ..., SN) for switching the parallel resistor (R1, ..., RN) on or off are present in each current branch (21, ..., 2N), the series resistor being subjected to open-loop or closed-loop control in discrete stages by switching at least one of the switches (S1, ..., SN) on or off,
N current branches (21, ..., 2N) being present, N being a natural number greater than or equal to 2, 2^{N} switch configurations being present owing to switching the N switches (S1, ..., SN) on or off and in particular being switchable, the series resistor being subjected to open-loop or closed-loop control in stages by a sequence of switch configurations over time,
the sequence of switch configurations over time being carried out such that a predetermined current-time progression or light output-time progression (Pₒᵤₜ(t)) is realized for the light source (5), and:
a) a first sequence over time of the switch configuration being carried out in such a way that, at the beginning of a current pulse, a first series resistance is set, preferably for generating rise times of the light output in the range of 0.1 -100 microseconds, and this series resistance is increased in stages by changing the switch configuration, in particular after each time interval in the range of 1 microsecond or in the range of 1 ns - 1000 ns; and
b) a second sequence over time of the switch configuration, in particular on a time scale in the range of 1 - 1000 microseconds, being carried out in such a way that, as time progresses, in particular after the first sequence over time, the light output (Pₒᵤₜ) of the light source (5) is controlled on the basis of a current measurement in the circuit (2) or a light output measurement of the current source (5) by changing the series resistance in stages; and
c) a third sequence over time of switch configurations, in particular on a time scale in the range of seconds or minutes, being carried out in such a way that, in the course of a current pulse, fluctuations in the light output (Pₒᵤₜ) of the light source (5) due to thermal effects, in particular in the voltage source (3) and/or in the parallel resistors (R1, ..., RN), are compensated for by changing the series resistance in stages.

2. The method according to claim 1, **characterized in that** the voltage source (3) is subjected to open-loop or closed-loop control in such a way that, at the beginning of a current pulse, the voltage is selected to be increased and thereafter reduced in stages, in order to realize an approximately rectangular curve shape of the light output (Pₒᵤₜ(t)) of the light source (5) as a function of time (t) and/or in order to reduce the power dissipation in the resistors.

3. The method according to either claim 1 or 2, **characterized in that** the light source is a laser system (5), e.g., a laser diode (5) or a diode-pumped laser (5), and the sequence over time of switch configurations is carried out such that the laser pulse shape and laser pulse frequency is adapted or optimized for ophthalmic applications, in particular for selective retina laser therapy.

4. The method according to claim 3, **characterized in that** the laser pulses are generated with a duration in the range of 0.5 - 50 microseconds, preferably 1-10 microseconds; and/or the laser pulses are generated with a rapid reproducible rise in the range of 0.1 - 5 microseconds, preferably 0.5 - 2 microseconds.

5. The method according to any of claims 1 to 4, wherein the method is applied in an ophthalmic laser treatment, in selective retina therapy (SRT) or in a micropulse/subthreshold laser method.

6. An ophthalmic laser treatment device, in particular for selective retina therapy (SRT) or for the micropulse/subthreshold laser method, comprising a driver circuit (1) for generating a current flow through a laser or a laser diode (LD),
**characterized in that**
a voltage source (3), the laser or the laser diode (LD), a series resistor and a switch are arranged in a circuit (2) of the driver circuit, the circuit (2) being branched into at least two parallel current branches (21, ..., 2N) in order to produce a series resistor, that can be subjected to open-loop or closed-loop control in discrete stages, for the laser or the laser diode (LD), and at least one switchable parallel resistor (R1, ..., RN) is present in each current branch (21, ..., 2N),
at least one switch (S1, ..., SN) for switching the parallel resistor (R1, ..., RN) on or off being present in each current branch (21, ..., 2N) of the driver circuit (1), and
the driver circuit (1) comprising means for carrying out the method according to any of claims 1 to 5.

7. The ophthalmic laser treatment device according to claim 6,
**characterized in that** the driver circuit (1)
a) comprises parallel resistors (R1, ..., RN) having the same resistance value; and/or
b) comprises parallel resistors (R1, ..., RN) having different resistance values, in particular in a series with doubled resistance values in each case (RN=2^{(N-1)}R1).

8. The ophthalmic laser treatment device according to either claim 6 or 7, **characterized in that**
a) in each current branch (21, ..., 2N) of the driver circuit (1), the switch (S1, ..., SN) is arranged in series with the parallel resistor (R1, ..., RN); and/or
b) the switches (S1, ..., SN) of the driver circuit (1) are MOSFET switches.

9. The ophthalmic laser treatment device according to any of claims 6 to 8, **characterized in that** the driver circuit (1) comprises digital electronics or a microcontroller (4) for driving the switches (S1, ..., SN), in particular **in that** the digital electronics or the microcontroller (4) is connected to each switch (S1, ..., SN) via a respective actuation path (A1, ..., AN).

10. The ophthalmic laser treatment device according to claim 9,
**characterized in that**
a) a current sensor (8) for measuring the current through the laser or the laser diode (LD) is present in the circuit (2) of the driver circuit (1) and is connected to the digital electronics or the microcontroller (4) via a feedback path (80) for controlling current intensity; and/or
b) a light sensor (6, 7) for measuring the light output (Pₒᵤₜ) of the laser or the laser diode (LD) is provided for the laser or the laser diode (LD) and is connected to the digital electronics or the microcontroller (4) via a feedback path (70) for controlling light output.

11. The ophthalmic laser treatment device according to any of claims 6 to 10, **characterized in that**
a) the voltage source (3) of the driver circuit (1) comprises means for changing its output voltage; and/or
b) the laser or a laser diode (LD) is a laser diode-pumped or LED-pumped laser system, in particular a diode-pumped solid-state laser (DPSSL) or a coherent optically pumped semiconductor laser (OPSL).

## Revendications

1. Procédé permettant de faire fonctionner un circuit d'attaque (1) pour la génération d'un flux de courant à travers une source lumineuse (5) d'un dispositif ophtalmologique de traitement au laser,
**caractérisé en ce que**
une source de tension (3), la source lumineuse (5), une résistance série et un commutateur sont disposés dans un circuit (2), dans lequel le circuit (2) est ramifié en au moins deux branches de courant (21, ..., 2N) parallèles, une résistance parallèle (R1, ..., RN) et un commutateur (S1, ..., SN) permettant d'activer ou de désactiver la résistance parallèle (R1, ..., RN) sont prévus dans chaque branche de courant (21, ..., 2N), dans lequel la résistance série est commandée ou régulée par paliers discrets en allumant ou en éteignant au moins l'un des commutateurs (S1, ..., SN),
dans lequel N branches de courant (21, ..., 2N) sont prévues, dans lequel N est un nombre naturel supérieur ou égal à 2, dans lequel 2^{N} configurations de commutateurs sont prévues par la mise en marche ou l'arrêt des N commutateurs (S1, ..., SN) et peuvent en particulier être commutées, dans lequel la résistance série est commandée ou régulée progressivement par une séquence temporelle de configurations de commutateurs,
dans lequel la séquence temporelle de configurations de commutateurs est réalisée de sorte qu'une courbe courant-temps ou une courbe puissance lumineuse-temps (Pₒᵤₜ(t)) prédéfinie est effectuée pour la source lumineuse (5), et dans lequel :
a) une première séquence temporelle de configuration de commutateurs est réalisée de sorte qu'au début d'une impulsion de courant, une première résistance série est mise en marche, de préférence pour la génération de temps de montée de la puissance lumineuse dans la plage de 0,1 à 100 microsecondes, et ladite résistance série est augmentée progressivement par la modification de la configuration de commutateurs, en particulier respectivement après un intervalle de temps dans la plage de 1 microseconde ou dans la plage de 1 ns à 1 000 ns ; et
b) une deuxième séquence temporelle de configuration de commutateurs, en particulier sur une échelle de temps dans la plage de 1 à 1 000 microsecondes, est réalisée de sorte que la puissance lumineuse (Pₒᵤₜ) de la source lumineuse (5) est régulée avec le temps, en particulier après la première séquence temporelle, par la modification progressive de la résistance série et en fonction d'une mesure de courant dans le circuit (2) ou d'une mesure de puissance lumineuse de la source de courant (5) ; et
c) une troisième séquence temporelle de configurations de commutateurs, en particulier sur une échelle de temps dans la plage de secondes ou de minutes, est réalisée de sorte que, au cours d'une impulsion de courant, des fluctuations de la puissance lumineuse (Pₒᵤₜ) de la source lumineuse (5) en raison d'effets thermiques, en particulier dans la source de tension (3) et/ou dans les résistances parallèles (R1, ..., RN), sont compensées par la modification progressive de la résistance série.

2. Procédé selon la revendication 1, **caractérisé en ce que** la source de tension (3) est commandée ou régulée de sorte qu'au début d'une impulsion de courant, la tension est choisie de manière à être augmentée puis est réduite progressivement pour effectuer une forme de courbe approximativement rectangulaire de la puissance lumineuse (Pₒᵤₜ(t)) de la source lumineuse (5) en fonction du temps (t) et/ou pour réduire la puissance dissipée dans les résistances.

3. Procédé selon l'une des revendications 1 ou 2, **caractérisé en ce que** la source lumineuse est un système laser (5), par ex. une diode laser (5) ou un laser à pompage par diodes (5), et la séquence temporelle de configurations de commutateurs est réalisée de sorte que la forme d'impulsion laser et la fréquence d'impulsion laser sont adaptées ou optimisées pour des applications ophtalmologiques, en particulier pour la thérapie sélective de la rétine au laser.

4. Procédé selon la revendication 3, **caractérisé en ce que** les impulsions laser sont générées avec une durée dans la plage de 0,5 à 50 microsecondes, de préférence 1 à 10 microsecondes ; et/ou les impulsions laser sont générées avec une montée rapide reproductible dans la plage de 0,1 à 5 microsecondes, de préférence 0,5 à 2 microsecondes.

5. Procédé selon l'une des revendications 1 à 4, dans lequel le procédé est utilisé dans un traitement au laser ophtalmologique, dans une thérapie sélective de la rétine (SRT) ou dans un procédé au laser à micropulsation/« sous-seuil ».

6. Dispositif ophtalmologique de traitement au laser, en particulier pour une thérapie sélective de la rétine (SRT) ou pour un procédé au laser à micropulsation/« sous-seuil », comprenant un circuit d'attaque (1) pour la génération d'un flux de courant à travers un laser ou une diode laser (LD),
**caractérisé en ce que**
une source de tension (3), le laser ou la diode laser (LD), une résistance série et un commutateur sont disposés dans un circuit (2) du circuit d'attaque, dans lequel, pour la génération d'une résistance série pouvant être commandée ou régulée par paliers discrets pour le laser ou la diode laser (LD), le circuit (2) est ramifié en au moins deux branches de courant (21, ..., 2N) parallèles et respectivement au moins une résistance parallèle (R1, ..., RN) pouvant être activée est prévue dans chaque branche de courant (21, ..., 2N),
dans lequel respectivement au moins un commutateur (S1, ..., SN) permettant d'activer ou de désactiver la résistance parallèle (R1, ..., RN) est prévu dans chaque branche de courant (21, ..., 2N) du circuit d'attaque (1), et
dans lequel le circuit d'attaque (1) comprend des moyens permettant de réaliser le procédé selon l'une des revendications 1 à 5.

7. Dispositif ophtalmologique de traitement au laser selon la revendication 6, **caractérisé en ce que** le circuit d'attaque (1)
a) comprennent des résistances parallèles (R1, ..., RN) comportant la même valeur de résistance ; et/ou
b) comprennent des résistances parallèles (R1, ..., RN) comportant des valeurs de résistance différentes, en particulier dans une série comportant des valeurs de résistance (RN = 2^{(N-1)}R1) respectivement doublées.

8. Dispositif ophtalmologique de traitement au laser selon l'une des revendications 6 ou 7, **caractérisé en ce que**
a) le commutateur (S1, ..., SN) est disposé en série avec la résistance parallèle (R1, ..., RN) dans chaque branche de courant (21, ..., 2N) du circuit d'attaque (1) ; et/ou
b) les commutateurs (S1, ..., SN) du circuit d'attaque (1) sont des commutateurs MOSFET.

9. Dispositif ophtalmologique de traitement au laser selon l'une des revendications 6 à 8, **caractérisé en ce que** le circuit d'attaque (1) comprend une électronique numérique ou un microcontrôleur (4) pour la commande des commutateurs (S1, ..., SN), en particulier **en ce que** l'électronique numérique ou le microcontrôleur (4) est connecté à chaque commutateur (S1, ..., SN) par l'intermédiaire de respectivement un chemin de commande (A1, ..., AN).

10. Dispositif ophtalmologique de traitement au laser selon la revendication 9, **caractérisé en ce que**
a) un capteur de courant (8) permettant de mesurer le courant à travers le laser ou la diode laser (LD) est prévu dans le circuit (2) du circuit d'attaque (1) et est connecté à l'électronique numérique ou au microcontrôleur (4) par l'intermédiaire d'un chemin de rétroaction (80) pour la régulation de l'intensité de courant ; et/ou
b) un capteur de lumière (6, 7) permettant de mesurer la puissance lumineuse (Pₒᵤₜ) du laser ou de la diode laser (LD) est prévu pour le laser ou la diode laser (LD) et est connecté à l'électronique numérique ou au microcontrôleur (4) par l'intermédiaire d'un chemin de rétroaction (70) pour la régulation de la puissance lumineuse.

11. Dispositif ophtalmologique de traitement au laser selon l'une des revendications 6 à 10, **caractérisé en ce que**
a) la source de tension (3) du circuit d'attaque (1) comprend des moyens permettant de modifier sa tension de sortie ; et/ou
b) le laser ou une diode laser (LD) est un système laser à pompage par diodes laser ou à pompage par DEL, en particulier un laser à solides à pompage par diodes (DPSSL) ou un laser à semi-conducteur à pompage par voie optique cohérente (OPSL).
